(19) Europäisches Patentamt
European Patent Office
Office européen des brevets

(11) **EP 3 654 028 A1**

(12) **EUROPEAN PATENT APPLICATION**

(43) Date of publication:
**20.05.2020 Bulletin 2020/21**

(51) Int Cl.:
***G01N 27/22*** *(2006.01)*

(21) Application number: **18306488.0**

(22) Date of filing: **14.11.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **MEAS France**
**31027 Toulouse Cedex 3 (FR)**

(72) Inventor: **Bez, Denis**
**31470 Fonsorbes (FR)**

(74) Representative: **Grünecker Patent- und Rechtsanwälte**
**PartG mbB**
**Leopoldstraße 4**
**80802 München (DE)**

(54) **RELATIVE HUMIDITY SENSOR DEVICE**

(57)     The present invention relates to a relative humidity sensor device, comprising a microcontroller and a sensing capacitor connected to a resistor. The microcontroller comprises a pulse width modulator with an output connected via the resistor to the sensing capacitor and an interrupt input connected to the sensing capacitor and a counter. Further, the microcontroller is configured to periodically charge and discharge the sensing capacitor via the resistor by means of the pulse width modulator, determine a number of interrupt events by means of the counter and determine a charging time of the sensing capacitor based on the determined number of interrupt events.

Fig. 1

EP 3 654 028 A1

## Description

## Field of Invention

The present invention relates to a relative humidity sensor device and, in particular, to means of data acquisition from a sensor element of the relative humidity sensor device.

## Background of the invention

Humidity can be measured by a number of techniques based on a resistance change and a capacitance change of a suitable material. In a semiconductor-based system for determining a relative humidity (ratio of the partial pressure of water vapor to the saturation vapor pressure of water at a given temperature) by means of measuring a capacitance, for example, humidity can be measured based on the reversible water absorption characteristics of polymeric materials serving as a capacitor dielectric.

A conventional capacitive relative humidity sensor device, in general, includes a semiconductor substrate, and a pair of electrodes, which are formed on a surface of the semiconductor substrate and face each other across a particular distance. A humidity-sensitive dielectric film is placed between the electrodes and formed on a surface of the semiconductor substrate. The capacitance of the film changes in response to humidity. The sensor detects humidity by detecting changes in capacitance between the pair of electrodes in response to variations in the surrounding humidity. Humidity sensing elements of the capacitance sensing type usually include a moisture-insensitive, non-conducting structure with appropriate electrode elements mounted or deposited on the structure, along with a layer or coating of a dielectric, highly moisture-sensitive material overlaying the electrodes and positioned so as to be capable of absorbing water from the surrounding atmosphere and attaining equilibrium in a short period of time.

The response offset and slope for the integrated relative humidity sensor device can be set to particular values in order to achieve a desired value of accuracy for the sensor. The accumulated charges of the capacitor element can be read out by means of an appropriate conditioning and data acquiring circuit that outputs a DC voltage or change is oscillation frequency of an oscillator that can be detected responsive to the accumulation of charges in the dielectric layer and represent measures of the capacitance and, thereby, a relative humidity. Based on the relative humidity and a detected temperature the absolute humidity and dew point can be determined. Thus, a dew point at a windscreen of a vehicle can be determined by means of a humidity sensor device, for example.

As already stated, in order to measure variation in the capacitance of a sensing capacitor that commonly has capacitance of some hundred pF a conditioning and data acquisition circuit has to be provided. The conditioning circuit can be some application specific integrated circuit or a discrete oscillator used to output a voltage or frequency as a function of the capacitance of the sensing capacitor. However, present-day conditioning circuits need relatively much space on a printed integrated circuit board, are relatively expensive and demand for a relatively high driving current.

In view of the above, it is an object of the present invention to provide for a technique of obtaining humidity data by means of a humidity sensing device based on the capacitance of a sensing capacitor and to provide a relative humidity sensor wherein the technique is implemented that reduces the relatively high demands for costs, electrical power and installation space of the art.

## Description of the Invention

The present invention addresses the above-mentioned problems by providing a relative humidity sensor according to claim 1. Thus, it is provided a relative humidity sensor device comprising a microcontroller and a sensing capacitor connected to a resistor. The microcontroller comprises a pulse width modulator (PWM) with an output connected via the resistor to the sensing capacitor and an interrupt input connected to a counter and to the sensing capacitor. The capacitor voltage is monitored via the interrupt input of the microcontroller. The counter can be realized as a software counter running on the microcontroller. Further, the microcontroller is configured to periodically charge and discharge the sensing capacitor (by providing a driving voltage) via the resistor by means of the pulse width modulator, determine a number of interrupt events (defined by voltage inputs at the interrupt input above a predetermined threshold, i.e., the high-level threshold of the interrupt input/pin) by means of the counter and determine a charging time of the sensing capacitor based on the determined number of interrupt events. A relative humidity of an environment can be determined based on the determined charging time of the sensing capacitor.

The PWM has a high-speed, for example, 16 bits timer/oscillator running in a range of 8 to 40 MHz, for example, in order to allow for a temporal resolution of some 125 ns to 25 ns. The charging time is the temporal duration to reach a constant capacitor voltage at the sensing capacitor. Whenever a voltage input equal to or exceeding an input voltage threshold is detected at the interrupt input a counter is incremented. Thereby the number of charging events occurring during a cycle of a number of periodic charging and discharging time periods provided by the PWM and, thus, the charging time of the individual charging events can be determined. By taking into account a number of charging and discharging processes noise can be reduced when determining the charging time. Based on the determined charging time and the capacitor voltage the capacitance that depends on the relative humidity of the environment can be determined. The capacitance translates to the relative humidity and based on the relative humidity and the temperature of the environment (that might also be measured by the relative humidity sensor device) a dew point can be determined. The provided sensor device is advantageous in terms of costs and installation space.

According to an embodiment the microcontroller is configured to

provide a first measurement cycle consisting of x periods, x being an integer, each period consisting of a sub-period of a HIGH state at the output of the PWM and a sub-period of a LOW state at the output of the PWM;

determine a number of interrupt events occurring during the first measurement cycle;

decrease the duration $T^1_{HIGH}$ of the sub-period of the HIGH state to obtain an adjusted duration $T^2_{HIGH}$ of the sub-period of the HIGH state, if the determined number of interrupt events equals or exceeds x / 2, and increase the duration $T^1_{HIGH}$ of the sub-period of the HIGH state to obtain an adjusted duration $T^2_{HIGH}$ of the sub-period of the HIGH state, if the determined number of interrupt events is below x / 2;

provide a second measurement cycle using the adjusted duration $T^2_{HIGH}$ of the sub-period of the HIGH state; and

determine a number of interrupt events occurring during the second measurement cycle by means of the counter and determine a charging time of the sensing capacitor based on the determined number of interrupt events occurring during the second measurement cycle. A relative humidity of the environment can be determined based on the thus determined charging time (determined based on the determined number of interrupt events occurring during the second measurement cycle) of the sensing capacitor.

Decrease of the duration of the sub-period of the HIGH state $T^1_{HIGH}$ can be performed according to $T^2_{HIGH} = T^1_{HIGH} - n \tau$, n being an integer (for example, larger than 2 or 4) and $\tau$ being an oscillator period of the PWM, and increase of the duration of the sub-period of the HIGH state $T^1_{HIGH}$ can be performed according to $T^2_{HIGH} = T^1_{HIGH} + n \tau$.

In particular, the microcontroller can be configured to iterate the providing of measurement cycles (first, second, third, fourth measurement cycle, etc.) and determining the number of interrupt events and obtaining adjusted durations $T^2_{HIGH}$, $T^3_{HIGH}$, $T^4_{HIGH}$, etc. of the sub-period of the HIGH state, until it is determined that the determined number of interrupt events switches between a value below x / 2 and a value equal to or above x / 2 for two or more consecutive measurement cycles, i.e., the procedure stabilizes for the searched charging time of the capacitor used as the sub-period of the HIGH state. During the iteration process the relative humidity can be determined and displayed to a user with increasing accuracy.

During the iteration process the adjustment steps n have not to be kept constant. In fact, the iteration process can be accelerated by choosing relatively large adjustment steps n at the beginning of the iteration process and smaller ones later on. For example, adjustment of the first sub-period of the HIGH state $T^1_{HIGH}$ ($T^2_{HIGH}$ = $T^1_{HIGH}$ - n $\tau$ or $T^2_{HIGH}$ = $T^1_{HIGH}$ + n $\tau$) can be performed with n= 128, adjustment of the second sub-period of the HIGH state $T^2_{HIGH}$ ($T^3_{HIGH}$ = $T^2_{HIGH}$ - n $\tau$ or $T^3_{HIGH}$ = $T^2_{HIGH}$ + n $\tau$) can be performed with n= 64, adjustment of the third sub-period of the HIGH state $T^3_{HIGH}$ ($T^4_{HIGH}$ = $T^3_{HIGH}$ - n $\tau$ or $T^4_{HIGH}$ = $T^3_{HIGH}$ + n $\tau$,)can be performed with n= 32, etc.

According to an embodiment the relative humidity sensor device further comprises a reference capacitor that is shielded against an environment and connected in parallel to the sensing capacitor and in series to the resistor. Moreover, the reference capacitor is connected to the same interrupt input of the microcontroller as the sensing capacitor. The reference capacitor can be used in order to compensate for self-heating of the microcontroller, for example. The relative humidity determined by means of the sensing capacitor (12, 312) $RH_{Csens}$ can be corrected to

$$RH^{corr} = K \cdot \frac{\left| RH_{Csens} - RH_{Cref} \right|}{RH_{Cref}} + O$$

where $RH_{Cref}$ is the relative humidity obtained by means of the reference capacitor (316) and $K$ and $O$ are determined from laboratory measurements.

It has to be noted, furthermore, that the sensing capacitor of the relative humidity sensor device is not a perfect capacitor. Rather, some parasitic resistance is present that can be corrected for. According to an embodiment the microcontroller is configured to correct the relative humidity determined by means of the sensing capacitor $RH_{Csens}$ to obtain a corrected relative humidity value $RH^{corr} = RH_{Csens} \cdot V_{factor}$ where $V_{factor} = R_p / (R_p + R)$ with $R$ being the resistance of the resistor through that the sensing capacitor and the reference capacitors are charged and discharged by the microcontroller and Rp being the resistance of the parasitic resistor.

The relative humidity sensor device may, additionally or alternative, be configured to further correct the relative humidity value $RH^{corr}$ obtained by means of both the sensing capacitor and the reference capacitor (see above) for an influence of a parasitic resistance having a resistance of $R_p$ to obtain a further corrected relative humidity value $RH^{corr}_{corr} = RH^{corr} \cdot V_{factor}$ where $V_{factor} = R_p / (R_p + R)$ with R being the resistance of the resistor.

The above-mentioned problems are also addressed by providing a method of determining a relative humidity of an environment by means of a relative humidity sensor device comprising a microcontroller including a pulse width modulator, PWM, and a sensing capacitor connected to a resistor and to an interrupt input of the microcontroller according to claim 10. The method comprises comprising the steps of periodically charging and discharging the sensing capacitor by a voltage output of the PWM during a first measurement cycle, detecting and counting interrupt events at the interrupt input of the microcontroller and determining a charging time of the sensing capacitor based on the determined number of interrupt events. Moreover, a relative humidity of the environment can be determined based on the determined charging time of the sensing capacitor.

The inventive method may further comprise the steps of

providing the first measurement cycle consisting of x periods, x being an integer, each period consisting of a sub-period of a HIGH state at the output of the PWM and a sub-period of a LOW state at the output of the PWM;

decreasing the duration $T1_{HIGH}$ of the sub-period of the HIGH state to obtain an adjusted duration $T2_{HIGH}$ of the sub-period of the HIGH state, if the determined number of interrupt events equals or exceeds x / 2, and increasing the duration $T1_{HIGH}$ of the sub-period of the HIGH state to obtain an adjusted duration $T2_{HIGH}$ of the sub-period of the HIGH state, if the determined number of interrupt events is below x / 2;

providing a second measurement cycle using the adjusted duration $T2_{HIGH}$ of the sub-period of the HIGH state; and

determining a number of interrupt events occurring during the second measurement cycle by means of the counter and determining a charging time of the sensing capacitor based on the determined number of interrupt events occurring during the second measurement cycle. A relative humidity of the environment can be determined based on the thus determined (namely for the second measurement cycle) charging time of the sensing capacitor.

Adjustment of the duration $T1_{HIGH}$ may be performed by decreasing the duration of the sub-period of the HIGH state $T1_{HIGH}$ according to $T2_{HIGH} = T1_{HIGH} - n \tau$, n being an integer and $\tau$ being an oscillator period of the PWM, and increasing the duration of the sub-period of the HIGH state $T1_{HIGH}$ according to $T2_{HIGH} = T1_{HIGH} + n \tau$.

Iteration of the above steps results in an accurate determination of the relative humidity. According to an embodiment the method, furthermore, comprises iterating the providing of measurement cycles and determining the number of interrupt events and obtaining adjusted durations of the sub-period of the HIGH state until it is determined that the determined number of interrupt events switches between a value below x / 2 and a value equal to or above x / 2 for two or more consecutive measurement cycles (see also detailed description below).

Moreover, the method according to embodiment may correct for errors occurring due to a work load of the microcontroller, in particular, self-heating of the microcontroller and a parasitic resistance of the capacitive sensor element. Thus, the method according to one of the above-described examples may comprise the additional steps of:

a) correcting the relative humidity determined by means of the sensing capacitor (12, 312) $RH_{Csens}$ to obtain a corrected relative humidity value

$$RH^{corr} = K \cdot \frac{\left| RH_{Csens} - RH_{Cref} \right|}{RH_{Cref}} + O$$

where $RH_{Cref}$ is the relative humidity obtained by means of a reference capacitor (316) shielded against the environment can connected parallel to the sensing capacitor and connected to the interrupt input of the microcontroller and $K$ and $O$ are determined from laboratory measurements, and, in particular,

further correcting the corrected relative humidity value $RH^{corr}$ for an influence of a parasitic resistance having a resistance of $R_p$ to obtain a further corrected relative humidity value $RH^{corr}_{corr} = RH^{corr} \cdot V_{factor}$ where $V_{factor} = R_p / (R_p + R)$ with $R$ being the resistance of the resistor (14, 314)

and/or

b) correcting the relative humidity determined by means of the sensing capacitor (12, 312) $RH_{Csens}$ for an influence of a parasitic resistance having a resistance of $R_p$ to obtain a corrected relative humidity value $RH^{corr} = RH_{Csens} V_{factor}$ where $V_{factor} = R_p / (R_p + R)$ with $R$ being the resistance of the resistor (14, 314).

The thus corrected values of the relative humidity can be presented, for example, by display, to a user of the relative humidity sensor device.

Furthermore, it is provided a computer program product comprising one or more computer readable media having computer-executable instructions for performing the steps of the method according to one of the above-described embodiments when run on a microcontroller of the relative humidity sensor device.

Additional features and advantages of the present invention will be described with reference to the drawings. In the description, reference is made to the accompanying figures that are meant to illustrate preferred embodiments of the invention. It is understood that such embodiments do not represent the full scope of the invention.

Figure 1 schematically illustrates a connection of a microcontroller to a relative humidity sensor element comprising a sensing capacitor and to a resistor through that the microcontroller charges and discharges the sensing capacitor according to an embodiment of the present invention.

Figure 2 illustrates an interrupt threshold voltage at an interrupt input of a microcontroller of a relative humidity sensor according to an embodiment of the present invention.

Figure 3 represents a flow chart illustrating an algorithm for determining the charging time of a sensing capacitor according to an embodiment of the present invention.

Figure 4 illustrates the measurement of the charging time of a sensing capacitor according to an embodiment of the present invention.

Figure 5 shows another embodiment of a humidity sensor comprising a reference capacitor.

Figure 6 shows a sensor element comprising a parasitic resistor.

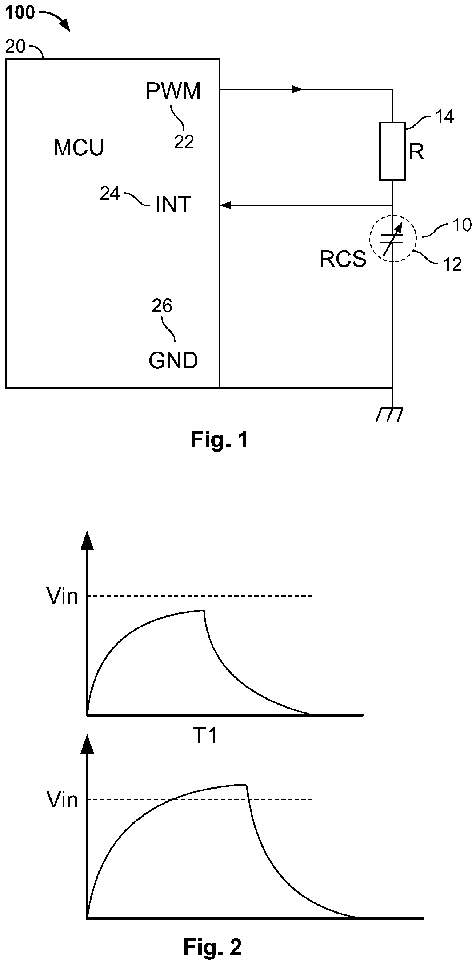

The present invention provides a relative humidity sensor comprising a microcontroller and a capacitive sensor element. The humidity sensor can determine a relative humidity and a dew point in an environment. Figure 1 shows parts of an embodiment of a humidity sensor 100. The humidity sensor 100 comprises a sensor element 10 comprising a sensing capacitor 12. The sensing capacitor 12 is connected in series to a resistor 14. The resistor 14 may have some hundred kOhm, for example, 470 kOhm.

The sensing capacitor 12 has a variable capacity depending on the humidity of the ambient conditions. For example, the sensing capacitor 12 comprises a pair of electrodes each of the electrodes being covered by a silicon nitride film and a humidity sensitive film. The humidity sensitive film is disposed between the electrodes and may also covers the electrodes (being formed above the silicon nitride film). A capacitance between the electrodes is changeable in accordance with humidity of atmosphere around the sensor. Based on the capacitance, the humidity is detected by the humidity sensor 100. The humidity sensitive film can be made of hygroscopic organic polymer such as poly-imide and butyric acetyl-cellulose. The sensing capacitor 12 may have a capacitance that varies in a range from 160 pF to 200 pF for a relative humidity in the full range of 0 % to 100 %.

The humidity sensor 100, furthermore, comprises a microcontroller 20. The microcontroller 20 comprises a pulse-width modulator (PWM) 22, for example, a 16 bits timer PWM. The PWM output provides a driving voltage $V_{dd}$ that is used to charge and discharge the sensing capacitor 12 automatically controlled by the timer clock of the PWM 22. The pulse-width modulator (PWM) 22 allows for a high-speed timer clock and may run at a frequency of between 8 to 40 MHz. At a timer speed, for example, of 32 MHz a temporal resolution (timer period) $\tau$ of about 31 ns per measurement point can be achieved for 300 measurement points in a 10 $\mu$s temporal meas-

urement range. This allows for detecting charging durations of the sensing capacitor 12 of about 100 $\mu$s. When the PWM output is in the HIGH state, the sensing capacitor 12 is charging through the resistor 14 and when the PWM output is in the LOW state (microcontroller 20 is functioning as short-circuit) the sensing capacitor 12 is discharged through the resistor 14.

Moreover, the microcontroller 20 comprises an interrupt input 24 that is connected to a software counter and it comprises a ground connection 26. The capacitor voltage is monitored via the interrupt 24 of the microcontroller 20. If the monitored voltage does not reach a predetermined input threshold voltage (interrupt threshold voltage) Vin during the charging process as it is illustrated in the upper row of Figure 2, there is no interrupt caused and the software timer connected to the interrupt input 24 is, consequently, not incremented. If, on the other hand, the monitored voltage does reach or exceed the predetermined input threshold voltage Vin during the charging process as it is illustrated in the lower row of Figure 2, an interrupt is triggered and the software timer connected to the interrupt input 24 is, consequently, incremented.

According to the invention the time of charging the sensing capacitor 12 can be determined with an accuracy up to the oscillator period $\tau$ (timer unit) of the PWM 22 or some multiple timer periods $\tau$ (for example, $\tau$ = 30 ns to 50 ns depending on the chosen oscillation frequency). From the determined charging time (and the reached constant voltage) the relative humidity can be derived since the functional dependence of the capacitance on the relative humidity of the used sensing transistor 12 is known beforehand. The charging time can be determined from the duration of a HIGH state of the PWM 22 of the microcontroller 20 that is needed to supply a voltage at the interrupt input 24 of the microcontroller 20 that is at or above the input threshold voltage Vin. By adjustment of the duty cycle (HIGH-LOW cycle comprising alternating HIGH and LO sub-periods) the duration of a HIGH state that is needed to detect an interrupt can be accurately determined.

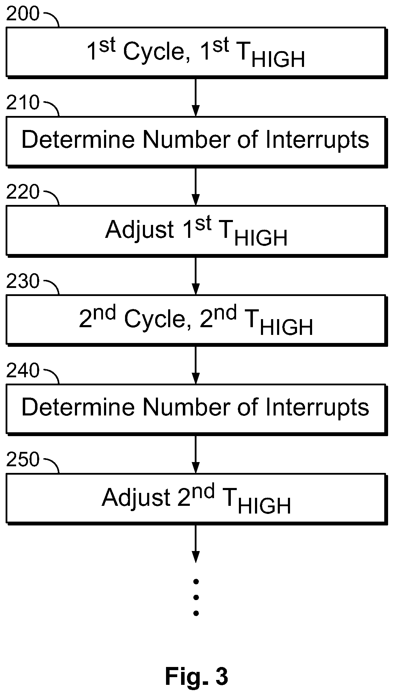

Figure 3 shows a flow chart of an algorithm for determining the charging time of the sensing capacitor 12 according to an embodiment of the present invention. A first measurement cycle with a first duration $T1_{HIGH}$ of HIGH states at the output of the PWM 22 is performed 200 wherein the cycle comprises x periods T with x being an integer larger than 2 or 4, for example, x = 10 periods T, each of which consists of one sub-period of a HIGH state at the output of the PWM 22 and a sub-period of a LOW state at the output of the PWM 22. The period T has to be chosen such that completely discharging of the sensing capacitor 22 is guaranteed in order not to corrupt the following charging process. For example, T = 1 ms or T = 2 ms. Note, that the PWM period T can be set in the timer period register and the first duration $T1_{HIGH}$ of HIGH states in the timer output compare register; the duration of the LOW states is given as a consequence of these settings.

It is determined 210 how many interrupts occur during the first measurement cycle. Depending on the determined number of interrupts the first duration $T^1_{HIGH}$ of HIGH states is adjusted 220 to obtain a second $T^2_{HIGH}$ of HIGH states to be used in a second measurement cycle 230. If the determined number of interrupts equals or exceeds $x / 2$, for example 5, then $T^2_{HIGH} = T^1_{HIGH} - n \tau$, n being an integer. If the determined number of interrupts is below $x / 2$, for example 5, then $T^2_{HIGH} = T^1_{HIGH} + n \tau$.

In the second measurement cycle, again, the number of interrupts is determined 240. Again, depending on the determined number of interrupts the duration of HIGH states (now $T^2_{HIGH}$) is adjusted. The procedure is iterated (with $T^2_{HIGH} = T^1_{HIGH} - n \tau$ or $T^2_{HIGH} = T^1_{HIGH} + n \tau$, $T^3_{HIGH} = T^2_{HIGH} - n \tau$ or $T^3_{HIGH} = T^2_{HIGH} + n \tau$, $T^4_{HIGH} = T^3_{HIGH} - n \tau$ or $T^4_{HIGH} = T^3_{HIGH} + n \tau$, etc.) until switching between two durations of HIGH states in two or more consecutive measurement cycles results in alternating determined numbers of interrupts above (or equal to) and below $x / 2$. In this final state of stabilized iteration, the charging time is determined with an accuracy of $n \tau$. The adjusted HIGH state value resulting from the iteration is directly the raw value for the charging time. If the adjustments of the first duration $T^1_{HIGH}$ of HIGH states (duration of the sub-period of the HIGH state), second duration $T^2_{HIGH}$ of HIGH states, third duration $T^3_{HIGH}$ of HIGH states, etc. is done in steps of $\tau$ (n=1), the above-described iteration procedure is rather slow and power consuming. In order to accelerate the iteration procedure one may select a varying step size n, for example, starting from n = 128 to adjust the first duration $T^1_{HIGH}$, setting n = 64 to adjust the second duration $T^2_{HIGH}$ and setting n = 32, 16, 8, 4, 2, 1 in the following adjustment steps. Moreover, one might start the iteration procedure with a $T^1_{HIGH}$ that corresponds to a relative humidity of 50 % under laboratory conditions. Implementing these actions the iteration procedure can usually be completed after only less than 10 iteration steps.

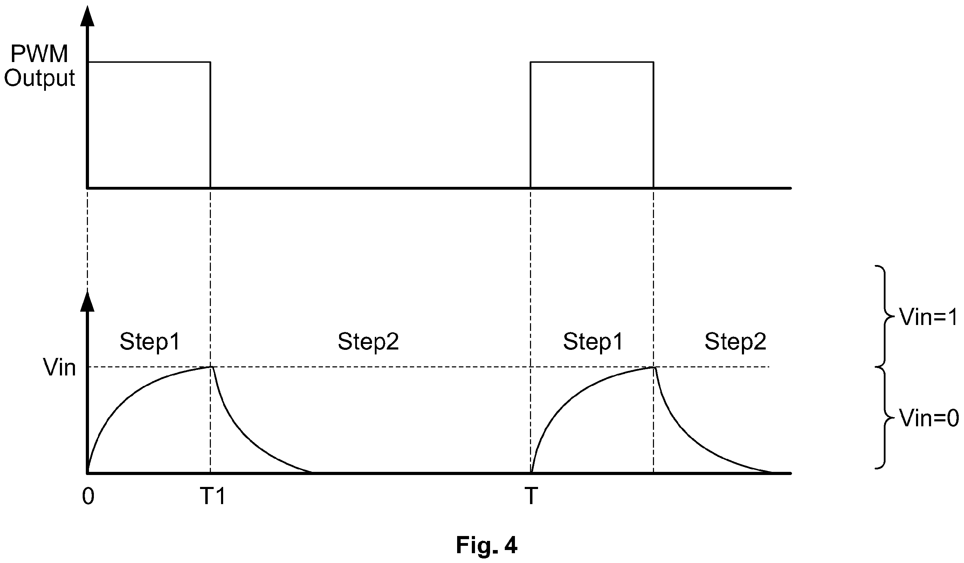

The measurement procedure is further illustrated in Figure 4. The upper row shows alternating HIGH and LOW states of the output of the PWM 22 of the microcontroller 20. The lower row shows the corresponding voltage-time (V-t) curves of the charging and discharging processes over more than one period T. Charging occurs in Step 1 (over time sub-period $T_1$) and discharging occurs in Step 2. In the example shown in Figure 4, the input threshold voltage Vin is reached (Vin = 1) two times at the respective ends of the charging periods $T_1$. From the reached constant voltage Vin and the determined charging time the capacitance and, thus, the relative humidity can be determined. According to a particular example, the above described procedure obtains $T_1$ = 95 $\mu$s (corresponding to 3035 timer periods $\tau$ = 31 ns) for a relative humidity of 0 % to $T_1$ = 105 $\mu$s (corresponding to 3354 timer periods $\tau$ = 31 ns) for a relative humidity of 100 %. For these values, other relative humidity values are determined according to relative humidity % = 100 (determined number of timer periods $\tau$ needed for charging - 3035) / (3354 - 3035).

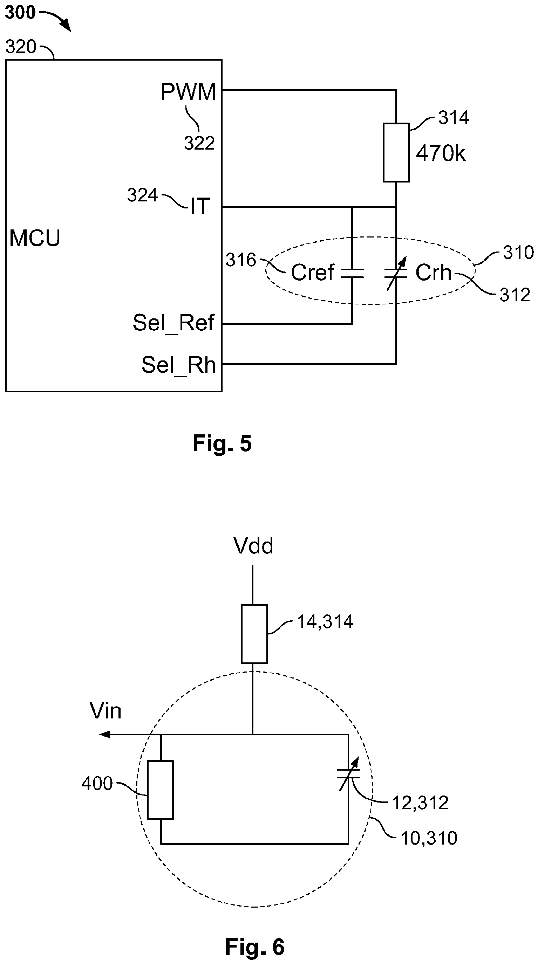

It has to be noted that the input threshold voltage Vin of the interrupt input 24 can slightly change with time due, for example, the load of the microcontroller and temperature changes due to self-heating. In order to account for a changing input threshold voltage Vin according to an embodiment a reference capacitor 316 is provided as shown in Figure 5. The humidity sensor 300 shown in Figure 5 comprises a sensor element 310 comprising a sensing capacitor 312 and a reference capacitor 316 connected in parallel to the sensing capacitor 312. Both the sensing capacitor 312 and the reference capacitor 316 are connected in series to a resistor 314 through which charging and discharging of the capacitors occur. The sensing capacitor 312 may be the same as the one shown in Figure 1 (see reference numeral 12) and the resistor 314 may be the same as the one shown in Figure 1 (see reference numeral 14). The reference capacitor 316 has a fixed capacity and may have a capacity of 180 pF equivalent to a relative humidity of 55 %, for example. Different from the sensing capacitor 312 the reference capacitor 316 is shielded from the environment the relative humidity of which is to be sensed by the sensing capacitor 312.

The humidity sensor 300 shown in Figure 5 further comprises a microcontroller 320. The microcontroller 320 comprises a pulse-width modulator (PWM) 322, for example, a 16 bits timer PWM. The PWM output is used to charge and discharge the sensing capacitor 312 automatically controlled by the timer clock / oscillator of the PWM 322. The PWM 322 may be the same as the one shown in Figure 1 (see reference numeral 22). The sensing capacitor 312 and the reference capacitor 316 are connected to the same interrupt input 324 of the microcontroller. Measurement of either the sensing capacitor 312 or the reference capacitor 316 is controlled by the connections Sel_Rh and Sel_Ref, respectively. For example, the sensing capacitor 312 is measured for Sel_Rh = Level 1 and Sel_Ref = Level 0 and the reference capacitor 316 is measured for Sel_Rh = Level 0 and Sel_Ref = Level 1.

Since the calibrated reference capacitor 316 is shielded against the environment varying measurement results from measurements made by the reference capacitor 316 reflect variations of the input threshold voltage Vin of the interrupt input 24, particularly, due to self-heating of the microcontroller 320. Therefore, the measurement results from measurements made by the reference capacitor 316 can be used to compensate the measurement results from measurements made by the sensing capacitor 312 for the effects of variations of the input threshold voltage Vin. The compensation can quantitatively be determined by measurements in a perfectly controlled closed laboratory environment in which the relative humidity and temperature are accurately regulated.

According to an example, a corrected relative humidity $RH^{corr}$ of an environment can be determined from the measurement of the relative humidity (raw data) obtained by means of the reference capacitor 316 $RH_{Cref}$ and the measurement of the relative humidity (raw data) obtained by means of the sensing capacitor 312 $RH_{Csens}$ by

$$RH^{corr} = K \cdot \frac{\left|RH_{Csens} - RH_{Cref}\right|}{RH_{Cref}} + O$$

where the slope $K$ and the offset $O$ (calibration coefficients) are temperature dependent and determined from the laboratory measurements. Comparative measurements made by a perfectly calibrated control sensor provided in the laboratory environment have proven that the thus determined corrected values of relative humidity $RH^{corr}$ are correct within an error range of about 3 % in a temperature range of -45 °C and 45 °C. The measurement by the reference capacitor 316 $RH_{Cref}$ also follows the above-described iteration procedure, suitably starting with a $T1_{HIGH}$ that corresponds to a relative humidity equivalent to the fixed capacity of the reference capacitor 316, i.e., a relative humidity of 55 % in the above-mentioned example.

After completion/stabilization of the iteration processes continued measurements may be performed in order to continuously monitor relative humidity and/or dew point. For example, 4 measurements may be performed each second by the sensing capacitor 312, for example, with adjustment steps of 8 $\tau$, 4 $\tau$, 2 $\tau$ and 1 $\tau$, and 2 measurements by the reference capacitor 316 with adjustment steps of 2 $\tau$ and 1 $\tau$. Moreover, if it is determined that the direction of adjustment (plus or minus) is constant over the four measurements of the sensing capacitor 312 in a following measurement cycle larger steps can be chosen, for example, 32 $\tau$, 16 $\tau$, 8 $\tau$ and 4 $\tau$ in order to speedily output an rougher estimated value for the relative humidity and/or dew point followed by a fine tuning based on smaller adjustment steps.

According to another embodiment the measured relative humidity can be further corrected. In fact, the sensor element 10 of the humidity sensor device 100 shown in Figure 1 and the sensor element 310 of the humidity sensor device 300 shown in of Figure 5 do not comprise perfect sensing capacitors 12 and 312, respectively. Rather, some parasitic resistor 400 is present (parallel to the sensing capacitor 12, 312) as shown in Figure 6. The parasitic resistance depends on the manufacturing process and may vary between 5 MOhm and 30 MOhm. Thus, when the PWM 22, 322 charges with a driver voltage of $V_{dd}$ the sensing capacitor 12, 312 is charged via the resistor 14, 314 with $V_{dd} \cdot V_{factor}$ rather the $V_{dd}$ with $V_{factor} = R_p / (R_p + R)$ where $R_P$ is the resistance of the parasitic resistor 400 and R is the resistance of the resistor 14, 314. The measured relative humidity RH can then be corrected by $RH^{corr} = RH \cdot V_{factor}$. For a resistance of the parasitic resistor 400 of $R_p = 5$ MOhm a correction factor of $V_{factor} = 0.91$ has to be taken into account, for example. The correction factor of $V_{factor}$ can be calculated from a measurement of Vin after full charge of the sensing capacitor 12, 312.

The above-described embodiments allow for a cost-saving and space-saving implementation and are particular suitable for mass production of relative humidity sensors that, for example, can be used for automotive applications.

All previously discussed embodiments are not intended as limitations but serve as examples illustrating features and advantages of the invention. It is to be understood that some or all of the above described features can also be combined in different ways.

**Claims**

1. A relative humidity sensor device (100, 300), comprising
   a microcontroller (20, 320);
   a sensing capacitor (12, 312) connected to a resistor (14, 314); and
   wherein the microcontroller (20, 320) comprises a pulse width modulator, PWM, (22, 322) with an output connected via the resistor (14, 314) to the sensing capacitor (12, 312) and an interrupt input (24, 324) connected to the sensing capacitor (12, 312) and a counter; and
   wherein the microcontroller (20, 320) is configured to periodically charge and discharge the sensing capacitor (12, 312) via the resistor (14, 314) by means of the pulse width modulator (22, 322), determine a number of interrupt events by means of the counter and determine a charging time of the sensing capacitor (12, 312) based on the determined number of interrupt events.

2. A relative humidity sensor device (100, 300) according to claim 1, wherein the microcontroller (20, 320) is configured to
   provide a first measurement cycle consisting of x periods, x being an integer, each period consisting of a sub-period of a HIGH state at the output of the PWM and a sub-period of a LOW state at the output of the PWM;
   determine a number of interrupt events occurring during the first measurement cycle; and
   decrease the duration $T1_{HIGH}$ of the sub-period of the HIGH state to obtain an adjusted duration $T2_{HIGH}$ of the sub-period of the HIGH state, if the determined number of interrupt events equals or exceeds x / 2, and increase the duration $T1_{HIGH}$ of the sub-period of the HIGH state to obtain an adjusted duration $T2_{HIGH}$ of the sub-period of the HIGH state, if the determined number of interrupt events is below x / 2;
   provide a second measurement cycle using the adjusted duration $T2_{HIGH}$ of the sub-period of the HIGH state; and
determine a number of interrupt events occurring during the second measurement cycle by means of the counter and determine a charging time of the sensing capacitor based on the determined number of interrupt events occurring during the second measurement cycle.

3. A relative humidity sensor device (100, 300) according to claim 1, wherein the microcontroller (20, 320) is configured to
decrease the duration of the sub-period of the HIGH state $T1_{HIGH}$ according to $T2_{HIGH} = T1_{HIGH} - n\,\tau$, n being an integer and $\tau$ being an oscillator period of the PWM, and to increase the duration of the sub-period of the HIGH state $T1_{HIGH}$ according to $T2_{HIGH} = T1_{HIGH} + n\,\tau$.

4. A relative humidity sensor device (100, 300) according to claim 2 or 3, wherein the microcontroller (20, 320) is configured to iterate the providing of measurement cycles and determining the number of interrupt events and obtaining adjusted durations of the sub-period of the HIGH state until it is determined that the determined number of interrupt events switches between a value below x / 2 and a value equal to or above x / 2 for two or more consecutive measurement cycles.

5. A relative humidity sensor device (100, 300) according to claim 4, wherein the integer n is decreased from one iteration step to the other.

6. A relative humidity sensor device (100, 300) according to one of the preceding claims, further comprising a reference capacitor (316) shielded against an environment and connected in parallel to the sensing capacitor (312) and in series to the resistor (314) and connected to the interrupt input (24, 324) of the microcontroller (100, 300).

7. A relative humidity sensor device (100, 300) according to claim 6, wherein the microcontroller (20, 320) is configured to correct the relative humidity determined by means of the sensing capacitor (12, 312) $RH_{Csens}$ to obtain a corrected relative humidity value

$$RH^{corr} = K \cdot \frac{\left| RH_{Csens} - RH_{Cref} \right|}{RH_{Cref}} + O$$

where $RH_{Cref}$ is the relative humidity obtained by means of the reference capacitor (316) and $K$ and $O$ are determined from laboratory measurements.

8. A relative humidity sensor device (100, 300) according to one of the preceding claims, wherein the microcontroller (20, 320) is configured to correct the relative humidity determined by means of the sensing capacitor (12, 312) $RH_{Csens}$ for an influence of a parasitic resistance having a resistance of $R_p$ to obtain a corrected relative humidity value $RH^{corr} = RH_{Csens} \cdot V_{factor}$ where $V_{factor} = R_p / (R_p + R)$ with $R$ being the resistance of the resistor (14, 314).

9. A relative humidity sensor device (100, 300) according to claim 7, wherein the microcontroller (20, 320) is configured to further correct the corrected relative humidity value $RH^{corr}$ for an influence of a parasitic resistance having a resistance of $R_p$ to obtain a further corrected relative humidity value $RH^{corr}_{corr} = RH^{corr} \cdot V_{factor}$ where $V_{factor} = R_p / (R_p + R)$ with $R$ being the resistance of the resistor (14, 314).

10. Method of determining a relative humidity of an environment by means of a relative humidity sensor device comprising a microcontroller (20, 320) including a pulse width modulator, PWM, (22, 322) and a sensing capacitor (12, 312) connected to a resistor (14, 314) and to an interrupt input (24, 324) of the microcontroller (20, 320), comprising the steps of:

periodically charging and discharging the sensing capacitor (12, 312) by a voltage output of the PWM (22, 322) during a first measurement cycle;
detecting and counting interrupt events at the interrupt input (24, 324) of the microcontroller (20, 320); and
determining a charging time of the sensing capacitor (12, 312) based on the counted number of interrupt events.

11. A method according to claim 10, further comprising providing the first measurement cycle consisting of x periods, x being an integer, each period consisting of a sub-period of a HIGH state at the output of the PWM and a sub-period of a LOW state at the output of the PWM;
decreasing the duration $T1_{HIGH}$ of the sub-period of the HIGH state to obtain an adjusted duration $T2_{HIGH}$ of the sub-period of the HIGH state, if the determined number of interrupt events equals or exceeds x / 2, and increasing the duration $T1_{HIGH}$ of the sub-period of the HIGH state to obtain an adjusted duration $T2_{HIGH}$ of the sub-period of the HIGH state, if the determined number of interrupt events is below x / 2;
providing a second measurement cycle using the adjusted duration $T2_{HIGH}$ of the sub-period of the HIGH state; and
determining a number of interrupt events occurring during the second measurement cycle by means of the counter and determining a charging time of the sensing capacitor based on the determined number of interrupt events occurring during the second measurement cycle.

12. A method according to claim 10 or 11, comprising decreasing the duration of the sub-period of the HIGH state $T^1_{HIGH}$ according to $T^2_{HIGH} = T^1_{HIGH} - n\ \tau$, n being an integer and $\tau$ being an oscillator period of the PWM, and increasing the duration of the sub-period of the HIGH state $T^1_{HIGH}$ according to $T^2_{HIGH} = T^1_{HIGH} + n\ \tau$.

13. A method according to claim 11 or 12, further comprising iterating the providing of measurement cycles and determining the number of interrupt events and obtaining adjusted durations of the sub-period of the HIGH state until it is determined that the determined number of interrupt events switches between a value below x / 2 and a value equal to or above x / 2 for two or more consecutive measurement cycles.

14. A method according to one of the claims 10 to 13, further comprising

c) correcting the relative humidity determined by means of the sensing capacitor (12, 312) $RH_{Csens}$ to obtain a corrected relative humidity value

$$RH^{corr} = K \cdot \frac{\left| RH_{Csens} - RH_{Cref} \right|}{RH_{Cref}} + O$$

where $RH_{Cref}$ is the relative humidity obtained by means of a reference capacitor (316) shielded against the environment can connected parallel to the sensing capacitor and connected to the interrupt input of the microcontroller and K and O are determined from laboratory measurements, and, in particular,
further correcting the corrected relative humidity value $RH^{corr}$ for an influence of a parasitic resistance having a resistance of $R_p$ to obtain a further corrected relative humidity value $RH^{corr}_{corr} = RH^{corr} \cdot V_{factor}$ where $V_{factor} = R_p / (R_p + R)$ with R being the resistance of the resistor (14, 314)
and/or

d) correcting the relative humidity determined by means of the sensing capacitor (12, 312) $RH_{Csens}$ for an influence of a parasitic resistance having a resistance of $R_p$ to obtain a corrected relative humidity value $RH^{corr} = RH_{Csens} \cdot V_{factor}$ where $V_{factor} = R_p / (R_p + R)$ with R being the resistance of the resistor (14, 314).

15. Computer program product comprising one or more computer readable media having computer-executable instructions for performing the steps of the method according to one of the Claims 10 to 14 when run on a microcontroller of the relative humidity sensor device.

100

20

PWM

MCU

22

24 INT

26

GND

14

R

RCS

10

12

**Fig. 1**

Vin

T1

Vin

**Fig. 2**

200 — | 1st Cycle, 1st $T_{HIGH}$ |

210 — | Determine Number of Interrupts |

220 — | Adjust 1st $T_{HIGH}$ |

230 — | 2nd Cycle, 2nd $T_{HIGH}$ |

240 — | Determine Number of Interrupts |

250 — | Adjust 2nd $T_{HIGH}$ |

**Fig. 3**

**Fig. 4**

**Fig. 5**

**Fig. 6**

Europäisches
Patentamt

European
Patent Office

Office européen
des brevets

# EUROPEAN SEARCH REPORT

Application Number

EP 18 30 6488

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | JP S59 43346 A (CITIZEN WATCH CO LTD)<br>10 March 1984 (1984-03-10)<br>* Abstract<br>page 269 col 3<br>page 271 line 5 to page 275 line 31<br>page 271 line 5 to page 275 line 31;<br>figures 4,9,12 * | 1-5,<br>10-13,15<br>6-9,14 | INV.<br>G01N27/22 |
| X<br>Y | US 2010/176891 A1 (TASHER NIR [IL] ET AL)<br>15 July 2010 (2010-07-15)<br>* page 4, lines 10-11 *<br>* paragraphs [0037], [0038], [0041],<br>[0054] - [0061] * | 1-5,<br>10-15<br>6-9 | |
| Y | WO 2006/002301 A1 (KELE INC [US])<br>5 January 2006 (2006-01-05)<br>* paragraphs [0032] - [0034], [0057] -<br>[0065]; claims 1, 9, 10 * | 6-8,14 | |
| Y | US 4 282 480 A (FUJITO KATSUYUKI ET AL)<br>4 August 1981 (1981-08-04)<br>* abstract *<br>* column 7, line 14 - column 9, line 34 * | 6,7,9,14 | TECHNICAL FIELDS SEARCHED (IPC)<br><br>G01N |
| Y | US 2008/024110 A1 (NIKOLAUS GERHARD [AT])<br>31 January 2008 (2008-01-31)<br>* abstract; figures * | 8,9,14 | |
| A | US 4 449 188 A (UNOGUCHI TAKEHIKO [JP] ET<br>AL) 15 May 1984 (1984-05-15)<br>* column 3, line 26 - column 13, line 20 * | 1-15 | |

The present search report has been drawn up for all claims

| Place of search | Date of completion of the search | Examiner |
|---|---|---|
| Munich | 4 March 2019 | Smith-Hewitt, Laura |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 18 30 6488

This annex lists the patent family members relating to the patent documents cited in the above-mentioned European search report.
The members are as contained in the European Patent Office EDP file on
The European Patent Office is in no way liable for these particulars which are merely given for the purpose of information.

04-03-2019

| Patent document cited in search report | | | Publication date | Patent family member(s) | | | Publication date |
|---|---|---|---|---|---|---|---|
| JP | S5943346 | A | 10-03-1984 | NONE | | | |
| US | 2010176891 | A1 | 15-07-2010 | TW | 201027904 | A | 16-07-2010 |
| | | | | US | 2010176891 | A1 | 15-07-2010 |
| WO | 2006002301 | A1 | 05-01-2006 | US | 2006006883 | A1 | 12-01-2006 |
| | | | | WO | 2006002301 | A1 | 05-01-2006 |
| US | 4282480 | A | 04-08-1981 | GB | 2020434 | A | 14-11-1979 |
| | | | | US | 4282480 | A | 04-08-1981 |
| US | 2008024110 | A1 | 31-01-2008 | CN | 101113966 | A | 30-01-2008 |
| | | | | DE | 102006034931 | A1 | 31-01-2008 |
| | | | | EP | 1882930 | A1 | 30-01-2008 |
| | | | | US | 2008024110 | A1 | 31-01-2008 |
| US | 4449188 | A | 15-05-1984 | GB | 2045442 | A | 29-10-1980 |
| | | | | JP | S6152424 | B2 | 13-11-1986 |
| | | | | JP | S55121145 | A | 18-09-1980 |
| | | | | US | 4449188 | A | 15-05-1984 |

EPO FORM P0459

For more details about this annex : see Official Journal of the European Patent Office, No. 12/82